# EUROPEAN PATENT APPLICATION

(11) **EP 4 279 993 A1**
(43) Date of publication of application: **22.11.2023**
(21) Application number: 22174097.0
(22) Date of filing: 18.05.2022
(51) Int. Cl.: G03F 7/20, G01N 21/956, G02F 1/33, G03F 9/00

(54) **SOURCE SELECTION MODULE AND ASSOCIATED METROLOGY APPARATUS**

(71) Applicant: ASML Netherlands B.V., 5500 AH Veldhoven (NL)
(72) Inventor: EURLINGS, Markus Franciscus Antonius, 5500 AH Veldhoven (NL); VAN GREEVENBROEK, Hendrikus, Robertus, Marie, 5500AH Veldhoven (NL)
(74) Representative: ASML Netherlands B.V.

(57) **Abstract**

Disclosed is a source selection module for selecting spectral characteristics of a broadband illumination beam to obtain a modulated illumination beam. The source selection module comprises a first beam dispersing element for dispersing the beam along a first direction, a second beam dispersing element for dispersing the beam along a second direction perpendicular to said first direction, a controllable diffractive element being operable to controllably spatially modulate the broadband illumination beam subsequent to being dispersed by said first beam dispersing element and said second beam dispersing element; and an aperture stop being operable to maximize transmission of one of specularly reflected radiation and diffracted radiation from said controllable diffractive element and minimize transmission of the other of said specularly reflected radiation and diffracted radiation.

## Description

### BACKGROUND

### Field of the Invention

The present invention relates to methods and apparatus usable, for example, in the manufacture of devices by lithographic techniques, and to methods of manufacturing devices using lithographic techniques. The invention relates more particularly to metrology sensors and lithography apparatuses having such a metrology sensor, and more particularly still to illumination arrangements for such metrology sensors.

### BACKGROUND ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.

In other applications, metrology sensors are used for measuring exposed structures on a substrate (either in resist and/or after etch). A fast and non-invasive form of specialized inspection tool is a scatterometer in which a beam of radiation is directed onto a target on the surface of the substrate and properties of the scattered or reflected beam are measured. Examples of known scatterometers include angle-resolved scatterometers of the type described in US2006033921A1 and US2010201963A1. In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

In some metrology applications, such as in some scatterometers or alignment sensors, imperfections in metrology targets can result in a wavelength/polarization dependent variation in a measured value from that target. As such, correction and/or mitigation for this variation is sometimes effected by performing the same measurement using multiple different wavelengths and/or polarizations (or more generally, multiple different illumination conditions). It would be desirable to improve switching and selection of the spectral components of illumination for such metrology applications.

### SUMMARY OF THE INVENTION

The invention in a first aspect provides a source selection module for selecting spectral characteristics of a broadband illumination beam to obtain a modulated illumination beam, the source selection module comprising: a first beam dispersing element for dispersing the broadband illumination beam, said first beam dispersing element being operable to disperse the broadband illumination beam along a first direction; a second beam dispersing element for dispersing the broadband illumination beam, said second beam dispersing element being operable to disperse the broadband illumination beam along a second direction perpendicular to said first direction; a controllable diffractive element having controllable elements arranged along the first direction such that a direction of periodicity of the controllable diffractive element comprises said first direction; the controllable diffractive element being operable to controllably spatially modulate the broadband illumination beam subsequent to being dispersed by said first beam dispersing element and said second beam dispersing element; and an aperture stop being operable to maximize transmission of one of specularly reflected radiation and diffracted radiation from said controllable diffractive element and minimize transmission of the other of said specularly reflected radiation and diffracted radiation.

The invention in a second aspect provides a source selection module for selecting spectral characteristics of a broadband illumination beam to obtain a modulated illumination beam, the source selection module comprising: at least one beam dispersing element for dispersing the broadband illumination beam, said at least one beam dispersing element being operable to disperse the broadband illumination beam along a first direction; a controllable diffractive element having controllable elements arranged along the first direction such that a direction of periodicity of the controllable diffractive element comprises said first direction; the controllable diffractive element being operable to controllably spatially modulate the broadband illumination beam subsequent to being dispersed by said first beam dispersing element; and an aperture stop being operable to maximize transmission of one of specularly reflected radiation and diffracted radiation from said controllable diffractive element and minimize transmission of the other of said specularly reflected radiation and diffracted radiation; and a plurality of lens elements comprising at least a lens or lens system operable to image the broadband illumination beam subsequent to being dispersed by the first beam dispersing element onto the controllable diffractive element, and to collect said modulated illumination beam from said controllable diffractive element; wherein said first beam dispersing element is also arranged to recombine the modulated illumination beam on a return path from the controllable diffractive element.

Also disclosed is a metrology apparatus and a lithographic apparatus comprising a metrology device being operable to perform the method of the first aspect or second aspect.

The above and other aspects of the invention will be understood from a consideration of the examples described below.

### BRIEF DESCRIPTION OF THE DRAWINGS

Embodiments of the invention will now be described, by way of example only, with reference to the accompanying drawings, in which:
Figure 1 depicts a lithographic apparatus;
Figure 2 depicts a schematic overview of a lithographic cell;
Figure 3 depicts a schematic representation of holistic lithography, representing a cooperation between three key technologies to optimize semiconductor manufacturing;
Figure 4 depicts a schematic overview of a scatterometry apparatus used as a metrology device, which may comprise a dark field digital holographic microscope according to embodiments of the invention;
Figure 5 comprises (a) a schematic diagram of a dark field scatterometer for use in measuring targets using a first pair of illumination apertures, (b) a detail of diffraction spectrum of a target grating for a given direction of illumination;
Figure 6 is a schematic illustration of a grating light valve, illustrating its basic operation in (a) a top view, (b) an end-on view in a first configuration and (c) an end-on view in a second configuration;
Figure 7 is a schematic illustration of the operating principle of an illumination arrangement comprising a grating light valve;
Figure 8 is a pupil representation illustrating the difficulty in optimizing aperture stop configuration for the arrangement of Figure 7;
Figure 9 is a pupil representation for an illumination arrangement according to an embodiment of the invention; and
Figure 10 is a schematic illustration of the operating principle of an illumination arrangement comprising a grating light valve according to an embodiment of the invention.

### DETAILED DESCRIPTION OF EMBODIMENTS

Before describing embodiments of the invention in detail, it is instructive to present an example environment in which embodiments of the present invention may be implemented.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

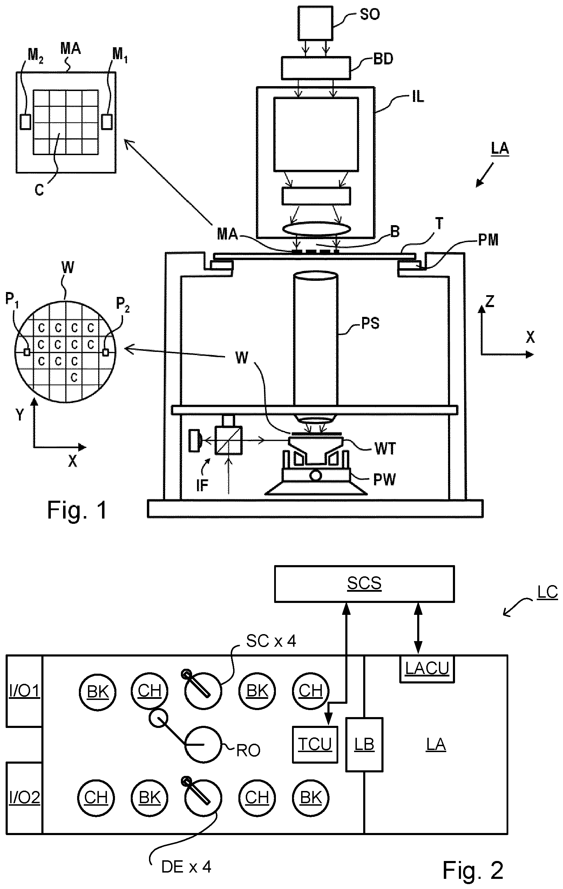

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

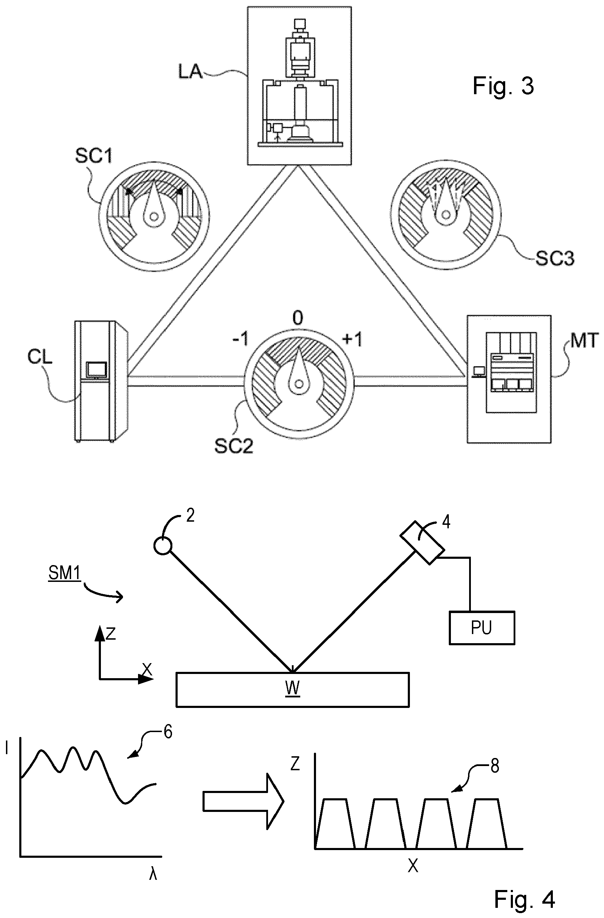

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

A metrology apparatus, such as a scatterometer, is depicted in Figure 4. It comprises a broadband (white light) radiation projector 2 which projects radiation onto a substrate W (optionally having been spectrally filtered to be narrowband prior to the substrate W) . The reflected or scattered radiation is passed to a spectrometer detector 4, which measures a spectrum 6 (i.e. a measurement of intensity as a function of wavelength) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Overall measurement quality of a lithographic parameter via measurement of a metrology target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

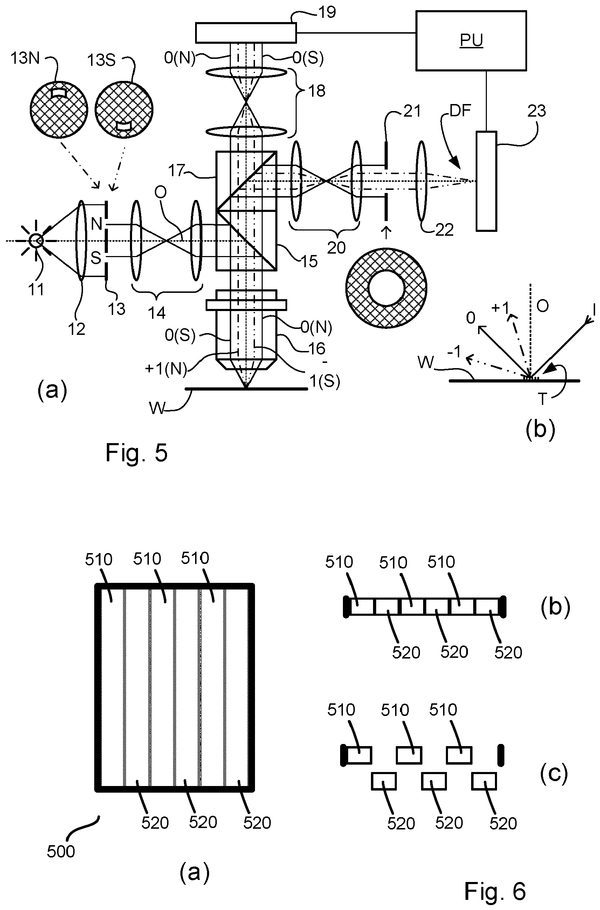

Another type of metrology apparatus is shown in Figure 5(a). A target T and diffracted rays of measurement radiation used to illuminate the target are illustrated in more detail in Figure 5(b). The metrology apparatus illustrated is of a type known as a dark field metrology apparatus. The metrology apparatus depicted here is purely exemplary, to provide an explanation of dark field metrology. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or + 1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In other examples, a two quadrant aperture may be used. This may enable simultaneous detection of plus and minus orders, as described in US2010201963A1, mentioned above. Embodiments with optical wedges (segmented prisms or other suitable elements) in the detection branch can be used to separate the orders for imaging spatially in a single image, as described in US2011102753A1, mentioned above. In yet other embodiments, 2nd, 3rd and higher order beams (not shown in Figure 5) can be used in measurements, instead of or in addition to the first order beams. In yet other embodiments, a segmented prism can be used in place of aperture stop 21, enabling both +1 and -1 orders to be captured simultaneously at spatially separate locations on image sensor 23.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented.

A light source for metrology applications usable for concepts disclosed herein may comprise any broadband source and a color selection arrangement to select one or more colors from the broadband output. By way of an example, the radiation source may be based on a hollow core or solid core fiber such as a hollow core photonic crystal fiber (HC-PCF) or solid core photonic crystal fiber (SC-PCF). For example, in the case of a HC-PCF, the hollow core of the fiber may be filled with a gas acting as a broadening medium for broadening input radiation. Such a fiber and gas arrangement may be used to create a supercontinuum radiation source. Radiation input to the fiber may be electromagnetic radiation, for example radiation in one or more of the infrared, visible, UV, and extreme UV spectra. The output radiation may consist of or comprise broadband radiation, which may be referred to herein as white light. This is only one example of a broadband light source technology usable in methods and apparatuses disclosed herein, and other suitable technologies may instead be employed.

When using metrology sensors, including those described above and/or other types of metrology sensors (e.g., alignment sensors, levelling sensors), it is often desirable to control the illumination spectrum, e.g., to switch the illumination between different wavelengths (colors) and/or wavefront profiles.

To perform color selection, a color selection module has been proposed which uses grating light valve (GLV) technology such as marketed by Silicon Light Machines (SLM), e.g., as described in US6947613B, incorporated herein by reference. A GLV is an electrically-programmable diffraction grating based on Micro-Electro-Mechanical Systems (MEMS) technology. Figure 6 illustrates the principal. Figure 6 is a schematic illustration of a GLV pixel or component 500 from (a) above and (b), (c) end-on. The GLV component comprises alternating GLV reflective ribbons of two types: static or bias ribbons 510 which are typically grounded along with a common electrode and driven or active ribbons 520 which are driven by an electronic driver channel. A GLV module may comprise any number of these GLV components 500 arranged in an array. The active and bias ribbons may be essentially identical other than in how they are driven. When no voltage is applied to the active ribbons 520, they are co-planar with the bias ribbons, a configuration illustrated in Figure 6(b). In this configuration, the GLV acts essentially as a mirror, with incident light being specularly reflected (i.e., forming specularly reflected radiation or zeroth diffraction order radiation). When a voltage is applied to the active ribbons 520, as illustrated in Figure 6(c), they deflect relative to the bias ribbons 510, establishing a square-well diffraction grating. In this state, incident light is diffracted into fixed diffraction angles. The ratio of light reflected with respect to light diffracted can be continuously varied by controlling the voltage on the active ribbons 520, which controls the magnitude of their deflection. As such, the amount of light diffracted by the GLV can be controlled in an analog fashion from zero (full specular reflection) to all incident light (zero specular reflection). This control of the amount of reflected radiation with respect to the amount of radiation diffracted into nonzero diffraction orders may be referred to as modulating the illumination within the context of this disclosure.

The GLV module may be used in a zeroth order mode such that the diffracted radiation is blocked/dumped and the specularly reflected (zeroth diffraction order) radiation is provided to the metrology tool. This has the advantage of preserving etendue. As such, an aperture stop may be provided in a pupil plane which with the aim of maximizing transmission of the zeroth order, and maximizing blocking (minimizing transmission) of the first orders (and other diffraction orders). However, diffraction angle is dependent on wavelength. In addition, spot size in the pupil plane may also be wavelength dependent, such that each color has a different spot size in the pupil plane. For example, a source presently used in some metrology applications may comprise a different etendue for different colors of light, such that respective beam widths for different colors are different.

Because of this, it is difficult to configure the aperture stop to maximize transmission of the zeroth order blocking of the first orders, for all wavelengths of interest (e.g., the wavelength band covered by a source selection module). Any particular shape or configuration for a hard aperture stop may be sub-optimal for certain wavelength ranges (e.g., may result in too much blockage of the zeroth order and/or too much leakage of first orders in the transmission window). As the used wavelength range increases, the problem becomes larger.

This issue is exacerbated when using a beam with a high etendue. A high etendue beam makes it difficult to minimize the spot size (per wavelength) on the GLV, and to have a low numerical aperture (NA) per order. A small spot on the GLV is highly desirable so as to operate on the flat area of the activated ribbons, and therefore not to lose contrast. A low NA of the orders is beneficial for separation of zeroth and first orders over a number of wavelengths.

A known color selection module arrangement based on a controllable diffractive element such as a GLV may comprise a beam dispersing element for dispersing the broadband illumination beam; a controllable diffractive element or GLV module for spatially modulating the broadband illumination beam subsequent to being dispersed; an aperture stop in the far field (a pupil plane, or conjugate thereof, of the GLV) to remove all but the wanted order(s) (e.g., to remove all but the zeroth order; however this may be reversed such that the zeroth order is blocked and first orders transmitted); and a beam combining element to recombine the spatially modulated broadband illumination beam to obtain an output source beam. The beam dispersing element may disperse the colors of a white light source over the GLV in a first direction (e.g., where the GLV is comprised in an image plane or field plane of the system). The combining element and dispersive element may be different elements or a single element.

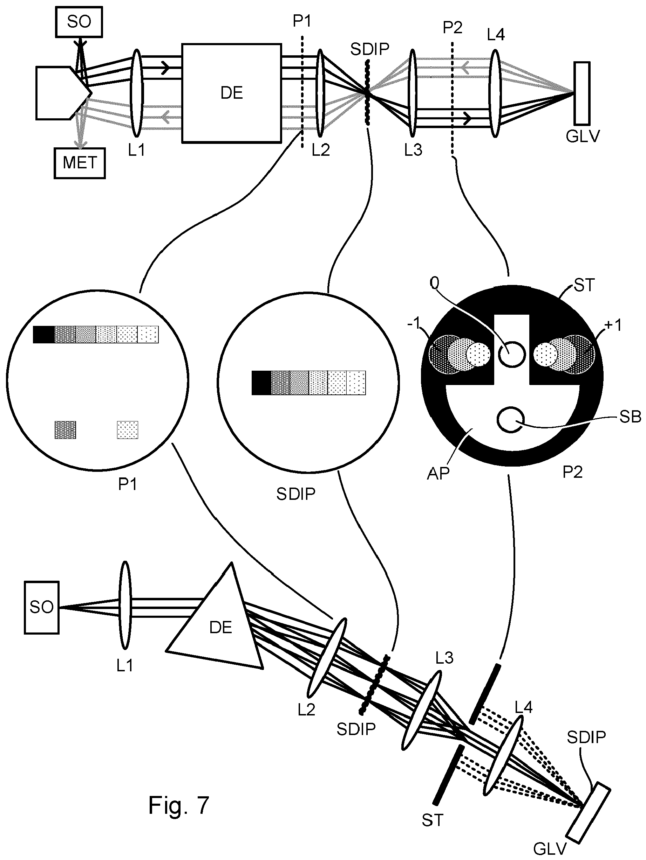

Figure 7 illustrates a color selection module arrangement based on a GLV. At the top of Figure 7 is a side view of the arrangement and at the bottom of the figure is the same arrangement in top-down view. A broadband source SO emits broadband radiation. A lens system represented by a plurality of lens elements (e.g., lenses L1 and L2) provide access to a pupil plane in which a beam dispersing element DE (e.g., a grating or prism) is located. The beam dispersing element DE disperses the broadband illumination beam onto the GLV, optionally (as shown here) via an intermediate image at a first spectrally dispersed image plane SDIP (or field plane) between lenses L2 and L3. Lens L4 focuses the spectrally dispersed radiation onto the GLV module GLV at a second spectrally dispersed image plane. The reflected (zeroth order) radiation from the GLV is captured by lens L4 (e.g., in this embodiment, i.e., where the incident radiation is focused onto the GLV and the spatially modulated reflected radiation captured from the GLV using the same lens arrangement). An aperture stop ST is located in a pupil plane provided by lens L4 to block any unwanted diffraction orders from the GLV module; e.g., to block first orders while passing the zeroth order substantially unattenuated. In the arrangement shown, the modulated illumination beam is recombined on the return path using the same dispersion element DE as was used to disperse the beam on the outward path. Lens L1 then focuses the output beam into a metrology device MET (e.g., into a suitable optical fiber such as a single mode fiber to transport the radiation to the metrology device MET).

It should be appreciated that, while this arrangement is shown to illustrate the problem of prior art arrangements being addressed by concepts disclosed herein, the actual arrangement shown is not prior art. A source selection module arrangement which uses the same optical components for the outward path to the GLV and return path form the GLV is not known from the prior art. This, for example, includes using a single element DE (e.g., prism) as a dispersing element in the outward path and combining element in the return path, and sharing all lenses including the imaging lens L4 to image the dispersed radiation onto the GLV and to collect the modulated radiation from the GLV. This is achieved by having a first off-axis beam path (outward path) to the GLV (colored black in the top figure, note that this aspect is only visible in the top figure) and a second off-axis beam path (return path) from the GLV (colored gray in the top figure). Prior art arrangements typically use separate optical branches to and from the GLV with dedicated optics per branch, and such arrangements are also within the scope of this disclosure.

Also shown in Figure 7 is a schematic representation of the light distribution at the lens L2 (plane PI). The top of the representation corresponds with the outward path and shows the dispersed source radiation; the bottom of the representation corresponds with the return path and shows the GLV modulated radiation (a purely exemplary color selection is shown). The grayscale shading is representative of different colors/wavelengths. The image representation at the spatially dispersed image plane SDIP is also shown, showing the dispersed beam in an image plane.

A pupil plane representation (plane P2), relating to a pupil plane of lens system comprising lenses L3 and L4 is also shown. This comprises the location of stop ST, defining an aperture AP configured to block the first diffraction orders +1,-1 (shown dotted in the bottom Figure, these are not visible in the top Figure) and transmit the zeroth order 0 and source beam SB. Note the different position in pupil plane (i.e., diffraction angle) and spot size/diameter per wavelength of the first diffraction orders +1,-1 (in which case the different colors will also have different diameters in the source beam SB). It is not essential that the different colors have different spot sizes and the concepts disclosed herein may be used with sources for which spot size is not wavelength dependent.

As has been explained, the aperture stop should maximize transmission of the zeroth order beams present (for all selected wavelengths), and minimize transmission of the 1st orders for all wavelengths (or *vice versa*). Maximizing transmission (e.g., of the zeroth order beams) should be understood to mean increasing transmission as much as is possible, given the limitation of the arrangement and trade-off required re minimizing transmission (e.g., of the 1st orders for all wavelengths). Similarly, minimizing transmission (e.g., of the 1st orders for all wavelengths) should be understood to mean to block these orders as much as possible given these same limitations and trade-off. In particular, the fact that the spots have spatially overlapping tails (if considering a plot of intensity or amplitude against pupil position for each spot) makes it necessary to either pass some unwanted light (leading to poor out-of-band contrast) or block the tails of the wanted zero order resulting in less signal and therefore less throughput. This issue increases the larger these spots are (i.e., the greater the NA of the beam) compared to the separation of the orders.

In an embodiment, maximizing transmission may comprise transmitting 90% or more, transmitting 95% or more, transmitting 98% or more or transmitting 99% or more of the transmitted radiation (e.g., the zeroth order radiation). In an embodiment, minimizing transmission may comprise blocking 90% or more, blocking 95% or more, blocking 98% or more or blocking 99% or more of the blocked radiation (e.g., the non-zeroth order diffracted radiation).

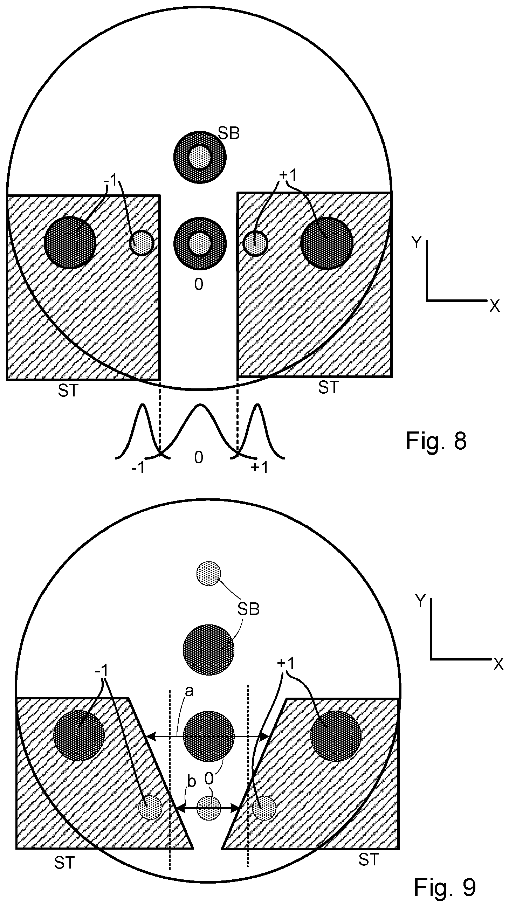

Figure 8 illustrates the issue in terms of a pupil representation with aperture stop ST shown. It shows a source beam SB, with only two wavelengths illustrated for clarity (represented by shading as before), and the corresponding zeroth order beam 0 and diffraction orders +1, -1. When the source beam SB is diffracted by the GLV, each of first diffraction orders +1, -1 are dispersed in a first direction, here labeled X, and when reflected, the source beam is specularly reflected into the zeroth order 0 (the ratio of diffraction into first diffraction orders +1, -1 and reflection into the zeroth order is controllable via the GLV as has been described). Below the pupil representation is a plot of intensity against pupil position in one dimension through the zeroth order beam 0 and diffraction orders +1, -1, and spatially aligned with the pupil representation. As can be seen from these intensity plots, the overlapping tails of the zeroth and first orders means that it is not possible in this case to optimally block the first orders; it must be the case that some zeroth order radiation is blocked or first order radiation transmitted. This is particularly the case when blocking the 1st order radiation for short wavelengths and transmitting the zeroth order for longer wavelengths.

To address this issue it is proposed to provide, in addition to a first beam dispersing element (e.g., prism or grating) that disperses a broadband illumination beam (e.g., source beam radiation) in a first direction in a (conjugate) image plane of a controllable (e.g., electrically-programmable) diffractive element or GLV, at least one second beam dispersing element (e.g., prism or grating) that disperses the broadband illumination beam in a second direction in a pupil plane of the controllable diffractive element or GLV. The first and second directions may be orthogonal with the first direction being the direction of periodicity of the GLV and the second direction being the direction each GLV ribbon extends. As such, the at least one second beam dispersing element may be located at the (conjugate) image plane of the GLV. This enables the aperture stop shape to be optimized for more optimal blocking of the unwanted radiation (e.g., non-zeroth or first diffraction orders from the GLV).

Figure 9 is an equivalent pupil representation to that of Figure 8, with the concepts disclosed herein implemented. Here the source beam SB is now dispersed in the second direction (here labeled Y) within this pupil plane due to the second beam dispersing element. While only two wavelengths are shown for clarity, it will be appreciated that the source beam may actually comprise many more wavelengths, e.g., a continuous wavelength band, and as such, the dispersed source beam may actually comprise a continuous dispersed spectrum (or multiple discrete wavelengths) in the second direction. As such, the position of the source radiation towards the GLV is wavelength dependent in this second direction (in the example shown the short WL has the larger angle of incidence onto the GLV; this is a design choice and may be reversed). The resulting zeroth order radiation 0 is similarly dispersed in the second direction. The first orders +1, -1 will also be dispersed in this second direction, and also in the first direction due to the diffraction by the GLV (the dispersion in the first direction will be the same as that of Figure 8).

This two dimensional dispersion of the first orders enables better optimization of the aperture stop configuration/shape, and more specifically such that the effective aperture size (e.g., in the first direction) differs per wavelength. As can be seen in the illustrated example of Figure 9, the diffracted radiation of a first (e.g., short) wavelength is subject to effective aperture size b, and the diffracted radiation of a second (e.g., long) wavelength is subject to effective aperture size a. The dotted line represent the compromise fixed aperture size in the Figure 8 example. As such, the aperture stop may be configured to comprise an aperture size in the first direction (e.g., at least for a portion (e.g., approximately half) of the pupil used for the optical return path downstream from the GLV) which varies (increases or decreases) in size along the second direction. The smaller apertures of such a continuously increasing aperture width (or stepwise increasing aperture width) may be located in the pupil region corresponding to the location in the second direction where diffracted orders will be diffracted to (in that second direction) which are also diffracted to smaller angles in the first direction and/or for which the spot size is smaller in the pupil. Similarly, the larger apertures or larger end of a continuously increasing aperture width may be located in the pupil region in the second direction corresponding to the location where diffracted orders will be diffracted to (in that second direction) which are also diffracted to larger angles in the first direction and/or for which the spot size is larger in the pupil.

It can be appreciated that the shape of such a continuously increasing aperture may vary from that shown, e.g., the aperture edges do not need to be straight lines as shown here; they may be curved from bottom to top (from the point of view of the illustration) or may increase step-wise for example. Alternatively or in addition, the aperture stop may comprise "soft" edges, which transmit/block in a non-binary fashion (e.g., the blocking part of the aperture at the edge may partially transmit radiation).

It should be appreciated that the GLV may be used in an opposite arrangement (higher order mode), where the wanted radiation is the diffracted radiation (e.g., first order radiation) and the unwanted radiation is the specularly reflected (zeroth order) radiation. In such an arrangement, the apertures may be inverted from those shown in the pupil region corresponding to the return path downstream of the GLV (but not to block the source beam in the outward path). For example, in Figure 9, such a stop may block the central region between the stop/blocked portions shown, to block the zeroth order 0, and transmit the first orders +1, -1.

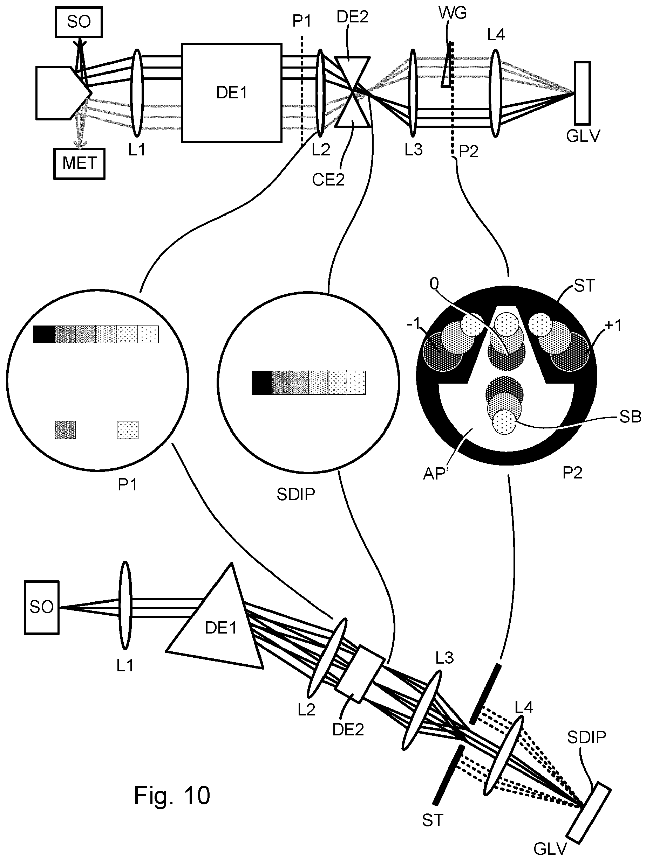

Figure 10 is a schematic illustration of an exemplary color selection module according to an embodiment. The arrangement is the same as that illustrated in Figure 7, except for the addition of a second beam dispersing element DE2, in addition to the first beam dispersing element DE1. In the arrangement shown, the second beam dispersing element DE2 is provided in the outward path for dispersing the source radiation in a pupil plane (e.g., P2) in a second direction. By contrast, the first beam dispersing element disperses the source radiation in an image plane in the first direction. In the return path, a second beam combining element CE2 is provided for recombining the illumination in said second direction. Note that in this embodiment, the first beam dispersing element DE1 doubles as the first beam combining element for recombining the illumination in said first direction; this is optional and a separate first beam combining element may be provided instead for recombining the illumination in said first direction.

The second beam dispersing element DE2 and second beam combining element CE2 may be located a conjugate image plane of the GLV. In addition to these elements DE2, CE2, a wedge WG (e.g., of low dispersion material) may be provided at plane P2 (e.g. a pupil plane defined by lens system L3, L4), which functions to separate the illumination in the outward path at said first spectrally dispersed image plane SDIP (e.g., at the approximate location of elements DE2, CE2). The second beam dispersing element DE2 and second beam combining element CE2 may comprise a pair of (e.g., similar but opposite oriented) dispersing elements or prisms.

As an alternative to the illustrated location of the second beam dispersing elements DE2a, DE2b it may be located immediately in front of the GLV (e.g., at, or to replace, an input window of the GLV). Second beam dispersing elements DE2a, DE2b may optionally comprise compound prisms such as Amici prisms.

The other main difference with the arrangement of Figure 7 is the pupil representation P2, with the source beam SB and all diffracted/reflected beams spectrally dispersed in the second direction, enabling a more optimal aperture shape AP' to be used, as has been described.

For simplicity, the beam path after the second beam dispersing elements DE2a, DE2b are not drawn tilted; in reality they may have to be tilted.

The source selection module based on a GLV enables control of the degree of transmission per color or band of the output beam, rather than simply switching colors/bands on and off.

Advantages of the proposed arrangements include providing the option of using a larger etendue source, enabling a higher achievable throughput (signal) for a given out of band (OoB) signal or conversely a better achievable OoB suppression for a given throughput (signal), and enabling a smaller minimum bandwidth (by enabling a smaller a spot on the GLV for a given throughput and OoB performance).

Further embodiments are disclosed in the subsequent list of numbered clauses:
1. A source selection module for selecting spectral characteristics of a broadband illumination beam to obtain a modulated illumination beam, the source selection module comprising:
   a first beam dispersing element for dispersing the broadband illumination beam, said first beam dispersing element being operable to disperse the broadband illumination beam along a first direction;
   a second beam dispersing element for dispersing the broadband illumination beam, said second beam dispersing element being operable to disperse the broadband illumination beam along a second direction perpendicular to said first direction;
   a controllable diffractive element having controllable elements arranged along the first direction such that a direction of periodicity of the controllable diffractive element comprises said first direction; the controllable diffractive element being operable to controllably spatially modulate the broadband illumination beam subsequent to being dispersed by said first beam dispersing element and said second beam dispersing element; and
   an aperture stop being operable to maximize transmission of one of specularly reflected radiation and diffracted radiation from said controllable diffractive element and minimize transmission of the other of said specularly reflected radiation and diffracted radiation.
2. A source selection module as defined in clause 1, wherein said controllable diffractive element comprises a grating light valve module.
3. A source selection module as defined in clause 1 or 2, wherein said first beam dispersing element is located in a pupil plane or conjugate thereof of the controllable diffractive element, so as to disperse the broadband illumination beam in an image plane or conjugate thereof of the controllable diffractive element.
4. A source selection module as defined in any preceding clause, wherein said second beam dispersing element is located in an image plane or conjugate thereof of the controllable diffractive element, so as to disperse the broadband illumination beam in a pupil plane or conjugate thereof of the controllable diffractive element.
5. A source selection module as defined in any preceding clause, further comprising at least a first beam combining element to recombine the modulated illumination beam in said first direction, to obtain an output source beam.
6. A source selection module as defined in any of clauses 1 to 4, wherein said first beam dispersing element is also arranged to recombine the modulated illumination beam on a return path from the controllable diffractive element.
7. A source selection module as defined in clause 6, wherein at least one lens element is shared between an outward path of the broadband illumination beam to the controllable diffractive element and the return path, the outward path comprising a first off-axis path and the return path comprising a second off axis path through the at least one lens element and first beam dispersing element.
8. A source selection module as defined in clause 7, wherein the least one lens element comprises at least a lens or lens system operable to image the broadband illumination beam subsequent to being dispersed by the first beam dispersing element and second beam dispersing element onto the controllable diffractive element, and to collect said modulated illumination beam from said controllable diffractive element.
9. A source selection module as defined in any preceding clause, further comprising at least a second beam combining element to recombine the modulated illumination beam in said second direction, to obtain an output source beam.
10. A source selection module as defined in any preceding clause, wherein the aperture stop is located in a pupil plane or conjugate thereof of the controllable diffractive element, and is operable to maximize transmission of said specularly reflected radiation from said controllable diffractive element and minimize transmission of said diffracted radiation from said controllable diffractive element.
11. A source selection module as defined in any preceding clause, wherein said first beam dispersing element and second beam dispersing element each comprise a prism.
12. A source selection module as defined in any preceding clause, wherein said aperture stop defines an aperture having an aperture size in said first dimension which varies along said second dimension for at least a portion of said pupil plane corresponding to a return path of said modulated illumination beam.
13. A source selection module as defined in clause 12, wherein said aperture size in said first dimension increases or decreases continuously or stepwise along said second dimension.
14. A source selection module for selecting spectral characteristics of a broadband illumination beam to obtain a modulated illumination beam, the source selection module comprising:
   at least one beam dispersing element for dispersing the broadband illumination beam, said at least one beam dispersing element being operable to disperse the broadband illumination beam along a first direction;
   a controllable diffractive element having controllable elements arranged along the first direction such that a direction of periodicity of the controllable diffractive element comprises said first direction; the controllable diffractive element being operable to controllably spatially modulate the broadband illumination beam subsequent to being dispersed by said first beam dispersing element;
   an aperture stop being operable to maximize transmission of one of specularly reflected radiation and diffracted radiation from said controllable diffractive element and minimize transmission of the other of said specularly reflected radiation and diffracted radiation; and
   a plurality of lens elements comprising at least a lens or lens system operable to image the broadband illumination beam subsequent to being dispersed by the first beam dispersing element onto the controllable diffractive element, and to collect said modulated illumination beam from said controllable diffractive element;
   wherein said at least one first beam dispersing element is also arranged to recombine the modulated illumination beam on a return path from the controllable diffractive element.
15. A source selection module as defined in clause 14, wherein each of said plurality of lens elements is shared between an outward path of the broadband illumination beam to the controllable diffractive element and the return path, the outward path comprising a first off-axis path and the return path comprising a second off axis path through the plurality of lens elements and at least one beam dispersing element.
16. A source selection module as defined in clause 14 or 15, wherein said controllable diffractive element comprises a grating light valve module.
17. A source selection module as defined in any preceding clause, comprising an illumination source for providing said input illumination.
18. A source selection module as defined in clause 17, wherein said illumination source comprises a hollow core fiber for confining a broadening medium and an excitation radiation source operable to provide excitation radiation for exciting said broadening medium.
19. A metrology device comprising the source selection module of any preceding clause to provide measurement illumination.
20. A metrology device as defined in clause 19, wherein the metrology device comprises a scatterometer.
21. A metrology device as defined in clause 20, comprising:
   a support for a substrate;
   an optical system for directing said measurement illumination to a structure on said substrate; and
   a detector for detecting the measurement radiation scattered by the structure on the substrate.
22. A metrology device as defined in clause 19, wherein the metrology device comprises an alignment sensor.
23. A lithographic apparatus comprising:
   a patterning device support for supporting a patterning device;
   a substrate support for supporting a substrate; and
   the metrology device of clause 22 being operable to perform alignment of said patterning device and/or said substrate support.

It should be appreciated that the term color is used throughout this text synonymously with wavelength or spectral component and the colors may include those outside the visible band (e.g., infrared or ultraviolet wavelengths).

While specific embodiments of the invention have been described above, it will be appreciated that the invention may be practiced otherwise than as described.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following claims and their equivalents.

## Claims

1. A source selection module for selecting spectral characteristics of a broadband illumination beam to obtain a modulated illumination beam, the source selection module comprising:
a first beam dispersing element for dispersing the broadband illumination beam, said first beam dispersing element being operable to disperse the broadband illumination beam along a first direction;
a second beam dispersing element for dispersing the broadband illumination beam, said second beam dispersing element being operable to disperse the broadband illumination beam along a second direction perpendicular to said first direction;
a controllable diffractive element having controllable elements arranged along the first direction such that a direction of periodicity of the controllable diffractive element comprises said first direction; the controllable diffractive element being operable to controllably spatially modulate the broadband illumination beam subsequent to being dispersed by said first beam dispersing element and said second beam dispersing element; and
an aperture stop being operable to maximize transmission of one of specularly reflected radiation and diffracted radiation from said controllable diffractive element and minimize transmission of the other of said specularly reflected radiation and diffracted radiation.

2. A source selection module as claimed in claim 1, wherein said controllable diffractive element comprises a grating light valve module.

3. A source selection module as claimed in claim 1 or 2, wherein said first beam dispersing element is located in a pupil plane or conjugate thereof of the controllable diffractive element, so as to disperse the broadband illumination beam in an image plane or conjugate thereof of the controllable diffractive element.

4. A source selection module as claimed in any preceding claim, wherein said second beam dispersing element is located in an image plane or conjugate thereof of the controllable diffractive element, so as to disperse the broadband illumination beam in a pupil plane or conjugate thereof of the controllable diffractive element.

5. A source selection module as claimed in any preceding claim, further comprising at least a first beam combining element to recombine the modulated illumination beam in said first direction, to obtain an output source beam.

6. A source selection module as claimed in any of claims 1 to 4, wherein said first beam dispersing element is also arranged to recombine the modulated illumination beam on a return path from the controllable diffractive element.

7. A source selection module as claimed in claim 6, wherein at least one lens element is shared between an outward path of the broadband illumination beam to the controllable diffractive element and the return path, the outward path comprising a first off-axis path and the return path comprising a second off axis path through the at least one lens element and first beam dispersing element.

8. A source selection module as claimed in claim 7, wherein the least one lens element comprises at least a lens or lens system operable to image the broadband illumination beam subsequent to being dispersed by the first beam dispersing element and second beam dispersing element onto the controllable diffractive element, and to collect said modulated illumination beam from said controllable diffractive element.

9. A source selection module as claimed in any preceding claim, further comprising at least a second beam combining element to recombine the modulated illumination beam in said second direction, to obtain an output source beam.

10. A source selection module as claimed in any preceding claim, wherein the aperture stop is located in a pupil plane or conjugate thereof of the controllable diffractive element, and is operable to maximize transmission of said specularly reflected radiation from said controllable diffractive element and minimize transmission of said diffracted radiation from said controllable diffractive element.

11. A source selection module as claimed in any preceding claim, wherein said first beam dispersing element and second beam dispersing element each comprise a prism.

12. A source selection module as claimed in any preceding claim, wherein said aperture stop defines an aperture having an aperture size in said first dimension which varies along said second dimension for at least a portion of said pupil plane corresponding to a return path of said modulated illumination beam.

13. A source selection module as claimed in claim 12, wherein said aperture size in said first dimension increases or decreases continuously or stepwise along said second dimension.

14. A source selection module as claimed in any preceding claim, comprising an illumination source for providing said input illumination.

15. A metrology device comprising the source selection module of any preceding claim to provide measurement illumination.
